# EUROPEAN PATENT APPLICATION

(11) **EP 4 131 388 A1**
(43) Date of publication of application: **08.02.2023**
(21) Application number: 20756741.3
(22) Date of filing: 13.04.2020
(51) Int. Cl.: H01L 27/32, H01L 51/56, C23C 14/24, C23C 14/04

(54) **DISPLAY PANEL AND PREPARATION METHOD THEREFOR, AND MASK**

(30) Priority: 26.03.2020 CN 202010222183
(71) Applicant: Wuhan China Star Optoelectronics Semiconductor Display Technology Co., Ltd., Wuhan, Hubei 430079 (CN)
(72) Inventor: PENG, Xudong, Hubei 430079 (CN)
(74) Representative: Murgitroyd & Company
(86) International application number: PCT/CN2020/084538
(87) International publication number: WO 2021/189562

(57) **Abstract**

A display panel, a manufacturing method thereof, and a mask plate are provided. The display panel includes several pixel units. Each of the pixel units includes four pixels. Each of the pixels includes first subpixels, second subpixels, and third subpixels. The first subpixels in each of the pixel units are disposed opposite to each other.

## Description

### RELATED APPLICATIONS

The present disclosure claims the priority of Chinese Patent Application No. CN202010222183.7 filed on March 26, 2020, titled "DISPLAY PANEL, MANUFACTURING METHOD THEREOF, AND MASK PLATE", which is incorporated by reference in the present application in its entirety.

### FIELD OF INVENTION

The present disclosure relates to the field of display, and particularly relates to a display panel, a manufacturing method thereof, and a mask plate.

### BACKGROUND OF INVENTION

Compared with traditional liquid crystal display (LCD) panels, organic light emitting diode (OLED) panels have advantages such as better energy saving characteristics, image performance, etc., and have obvious dominance in field of flexible displays and wearable displays. Furthermore, a light emitting layer in the OLEDs is evaporated in a high vacuum environment by mainly using an organic luminescent material, and when electric charges pass through, the light emitting layer can emit light.

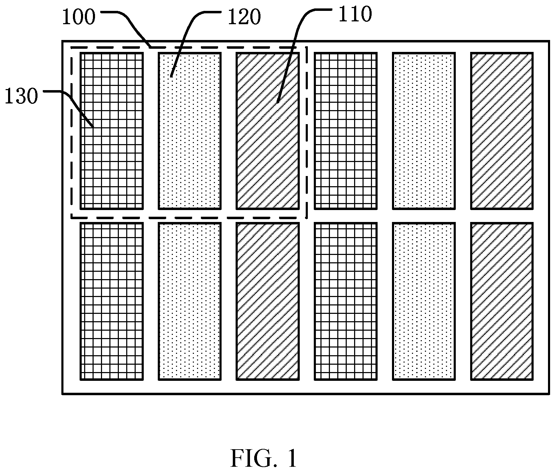

In a process of evaporating the light emitting layer, a fine metal mask (FMM) is used under a substrate to coat films in subpixels of three primary colors of red, green, and blue (RGB) and to isolate a subpixel region with unwanted colors and an uncoated region. As illustrated in FIG. 1, in a current display device, arrangement of the subpixels is usually a side-by-side arrangement. A first subpixel 110, a second subpixel 120, and a third subpixel 130 constitute a pixel 100, and each of the subpixels is rectangular.

With increasing requirements of high definition and high resolution from people, mainstream RGB arrangement methods have been difficult to meet production needs incurred by limitations from factors such as alignment accuracy of glass substrates, manufacturing level of FMMs, shadow effect, etc., while reducing gaps of a pixel definition layer and sizes of openings to increase pixel density also have problems such as color blend, etc. Therefore, considering a new pixel arrangement method to meet high pixels per inch (PPI) production needs is a path.

### SUMMARY OF INVENTION

The purpose of the present disclosure is to solve the technical problem of difficult to increase pixels of a display device during the pixels being evaporated by a mask plate.

In order to realize the purpose mentioned above, the present disclosure provides a display panel. Each of pixel units includes four pixels. Each of the pixels includes a plurality of first subpixels, a plurality of second subpixels, and a plurality of third subpixels. The plurality of first subpixels of each of the pixel units are disposed adjacently and form a first pixel sub-region. In two adjacent pixel units, the plurality of second subpixels of one of the pixel units and the plurality of second subpixels of another one of the pixel units are disposed adjacently and form a second pixel sub-region, the plurality of third subpixels of one of the pixel units and the plurality of third subpixels of another one of the pixel units are disposed adjacently and form a third pixel sub-region.

Furthermore, the plurality of pixels are squares, the plurality of first subpixels are triangles, the plurality of second subpixels are triangles, the plurality of third subpixels are triangles, and the triangles include right triangles.

Furthermore, when the plurality of first subpixels, the plurality of second subpixels, and the plurality of third subpixels are right triangles, two sides of the first subpixels forming a right angle are disposed correspondingly to two sides of a square where the pixel are located on, a hypotenuse of the second subpixels corresponds to and is parallel to a side of the pixels, and is disposed on an edge of the pixel units where the pixels are located on; and a hypotenuse of the third subpixel corresponds to and is parallel to a side of the pixels, and is disposed on an edge of the pixel units where the pixel are located on.

Furthermore, in the plurality of pixel units, right angles of the plurality of first subpixels of the four pixels are disposed oppositely, and the first pixel sub-region is a first rectangular region, and the first rectangular region is located at a center of the pixel units.

Furthermore, in two adjacent pixel units, the second pixel sub-region is a second rectangular region; and in two adjacent pixel units, the third pixel sub-region is a third rectangular region.

Furthermore, an area of the plurality of second subpixels is equal to an area of the plurality of third subpixels, and an area of the first subpixels is equal to a sum of the area of the plurality of second subpixels and the area of the plurality of third subpixels.

Furthermore, in each of the pixel units, one of the second subpixels and one of the third subpixels are disposed adjacently, two second subpixels are spaced apart, and two third subpixels are spaced apart.

In order to realize the purpose mentioned above, the present disclosure further provides a mask plate to manufacture the display panel mentioned above, including a plate body including a shielding region and an opening region, and the opening includes a first opening area, a second opening area, and a third opening area. Furthermore, a shape and a dimension of the first opening area corresponds to the first pixel sub-region of the display panel, a shape and a dimension of the second opening area corresponds to the second pixel sub-region of the display panel, and a shape and a dimension of the third opening area corresponds to the third pixel sub-region of the display panel.

Furthermore, shapes of the first opening area, the second opening area, and the third opening area are rectangular or rhombic.

In order to realize the purpose mentioned above, the present disclosure further provides a manufacturing method of a display panel, including following steps: a step of providing a substrate: providing a substrate; a step of placing a mask plate: placing the mask plate as claimed in claim 8 to make a first opening of the mask plate correspond to the first pixel sub-region of the substrate, a second opening of the mask plate correspond to the second pixel sub-region of the substrate, a third opening of the mask plate correspond to the third pixel sub-region of the substrate; an evaporation step: evaporating the substrate, which forms four adjacent first subpixels in the first pixel sub-region, forms two adjacent second subpixels in the second pixel sub-region, and forms two adjacent third subpixels in the third pixel sub-region, wherein one of the first subpixels, one of the second subpixels, and one of the third subpixels which are adjacent form one of the pixel units; and a step of removing the mask plate: removing the mask plate.

Technical effect of the present disclosure is that subpixels with a same color are close to each other and can be symmetrical to each other, which can lower a color blend phenomenon caused in an evaporation process to improve display effect of the display device. One opening of the mask plate corresponds to a rectangular region composed of subpixels with a same color, thereby improving pixel density of the display device.

### DESCRIPTION OF DRAWINGS

The technical solutions and other advantageous effects of the present invention will be apparent with reference to the following accompanying drawings and detailed description of embodiments of the present disclosure.
FIG. 1 is an arrangement method of pixels in a display panel in the prior art.
FIG. 2 is an arrangement method of pixel units in a display panel mentioned in an embodiment of the present disclosure.
FIG. 3 is a schematic diagram of a mask plate mentioned in an embodiment of the present disclosure.
FIG. 4 is a flowchart of a manufacturing method of the display panel mentioned in an embodiment of the present disclosure.

### DETAILED DESCRIPTION OF PREFERRED EMBODIMENTS

The technical solutions in the embodiments of the present disclosure are clearly and completely described in the following with reference to the accompanying drawings in the embodiments of the present disclosure. Obviously, the described embodiments are only part of the embodiments of the present disclosure, but are not all embodiments of the present disclosure. All other embodiments obtained by those skilled in the art based on the embodiments of the present disclosure without creative efforts are within the scope of the present disclosure.

In the description of the present disclosure, it is to be understood that the orientation or positional relationship indicated by the terms "center", "longitudinal", "transverse", "length", "width", "thickness", "upper", "lower", "front", "rear", "left", "right", "vertical", "horizontal", "top", "bottom", "inside", "outside", "clockwise", "counterclockwise" etc. is based on the orientation or positional relationship shown in the accompanying figures, which is merely for the convenience for describing of the present disclosure and for the simplification of the description, and is not intended to indicate or imply that the indicated devices or elements have a specific orientation or is constructed and operated in a specific orientation. Therefore, it should not be understood as a limitation on the present disclosure. Moreover, the terms "first" and "second" are used for descriptive purposes only and are not to be understood as indicating or implying relative importance or implicitly indicating the number of the indicated technical characteristics. Therefore, the characteristics defined by "first" or "second" may include one or more of the described characteristics either explicitly or implicitly. In the description of the present disclosure, the meaning of "a plurality" is two or more unless clearly and specifically defined otherwise.

In the description of the present disclosure, unless specified or limited otherwise, terms "mounted," "connected," "coupled," and the like are used in a broad sense, and may include, for example, fixed connections, detachable connections, or integral connections; may also be mechanical or electrical connections or may be communication between each other; may also be direct connections or indirect connections via intervening structures; may also be inner communications of two elements or may be a relationship of interaction between two elements. For persons skilled in the art in this field, the specific meanings of the above terms in the present disclosure can be understood with specific cases.

In the present disclosure, unless expressly specified or limited otherwise, a first feature is "on" or "beneath" a second feature may include that the first feature directly contacts the second feature and may also include that the first feature does not directly contact the second feature. Furthermore, a first feature "on," "above," or "on top of" a second feature may include an embodiment in which the first feature is right "on," "above," or "on top of" the second feature and may also include that the first feature is not right "on," "above," or "on top of" the second feature, or just means that the first feature has a sea level elevation higher than the sea level elevation of the second feature. While first feature "beneath," "below," or "on bottom of" a second feature may include that the first feature is "beneath," "below," or "on bottom of" the second feature and may also include that the first feature is not right "beneath," "below," or "on bottom of" the second feature, or just means that the first feature has a sea level elevation lower than the sea level elevation of the second feature.

The following disclosure provides many different embodiments or examples for implementing the different structures of the present disclosure. In order to simplify the disclosure of the present disclosure, the components and configurations of the specific examples are described below. Of course, they are merely examples and are not intended to limit the present disclosure. In addition, the present disclosure may repeat reference numerals and/or reference numerals in different examples, which are for the purpose of simplicity and clarity, and do not indicate the relationship between the various embodiments and/or arrangements discussed. Moreover, the present disclosure provides embodiments of various specific processes and materials, but one of ordinary skill in the art will recognize the use of other processes and/or the use of other materials.

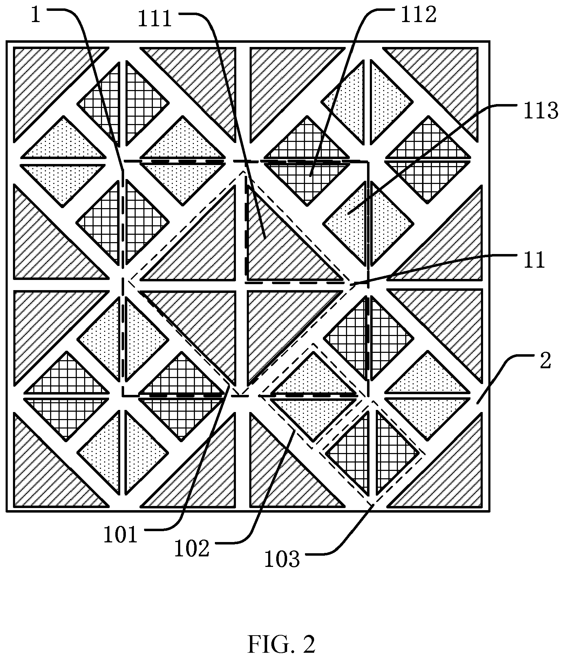

Specifically, an embodiment of the present disclosure provides a display device. The display device includes a display panel. Please refer to FIG. 2, the display panel includes several pixel units 1 and a pixel definition layer 2.

The pixel units 1 are a rectangular region. Intervals between each of the pixel units 1 are the pixel definition layer 2. The pixel definition layer 2 is used for defining sizes of light emitting layers, that is, sizes of the pixel units. Several via holes are defined on the pixel definition layer 2, and the pixel units 1 are disposed opposite to the via holes.

Each of the pixel units includes four pixels 11. Shapes of each of the pixels 11 are square. The pixel definition layer 2 is disposed between each of the pixels 11. Each of the pixels 11 includes three subpixels, which are respectively a first subpixel 111, a second subpixels 112, and a third subpixels 113.

The first subpixels 111 in each of the pixel units 1 are disposed opposite to each other. Shapes of the first subpixels are triangular, and in this embodiment, they are right triangles. Right angles of four first subpixels 111 are disposed opposite to each other. The four right angles are disposed opposite and symmetrical to each other. Two sides of the first subpixel 111 forming a right angle are respectively disposed opposite to two adjacent sides of the pixel 11 where the first subpixel 111 is located on, and the first subpixel 111 is disposed at a center of the pixel unit 1 where the first subpixel 111 is located on. Four first subpixels 111 constitute a first pixel sub-region 101. The first pixel sub-region 101 is a first rectangular region, and the first pixel sub-region 101 is disposed at a center of the pixel unit 1 where the first pixel sub-region 101 is located on. The subpixels with a same color are close to each other and distributed symmetrically, which can lower a color blend phenomenon during an evaporation process to improve display effect of the display panel.

Shapes of the second subpixels 112 are triangular. In this embodiment, they are preferred to be right triangles. In one of the pixels 11, hypotenuses of the second subpixels 112 are attached to one side of the pixel 11, and right angles of the second subpixels 112 directly face the second subpixel 111 and are disposed on an edge of the pixel unit 1 where the pixel 11 is located on. In one of the pixel units 1, the second subpixels 112 are spaced apart. In two adjacent pixel units 1, the second subpixels 112 of one of the pixel units 1 and the second subpixels 112 of another one of the pixel units 1 are disposed adjacently and form a second pixel sub-region 102. Specifically, hypotenuses of two second subpixels 112 are disposed opposite to each other. The two second subpixels 112 are disposed symmetrically to form the second pixel sub-region 102. The second pixel sub-region is a second rectangular region. The subpixels with a same color are close to each other and distributed symmetrically, which can lower a color blend phenomenon during an evaporation process to improve display effect of the display panel.

Shapes of the third subpixels 113 are triangular. In this embodiment, they are preferred to be right triangles. In one of the pixels 11, a hypotenuse of the third subpixel 113 is attached to one side of the pixel 11, and right angle of the third subpixel 113 directly face the second subpixel 111 and is disposed on an edge of the pixel unit 1 where the pixel 11 is located on. In one of the pixel units 1, the third subpixels 113 are spaced apart, and the second subpixels 112 and the third subpixels 113 are disposed adjacently. The third subpixel 113 of one of the pixel units 1 and the third subpixel 113 of another one of the pixel units 1 are disposed adjacently and form a third pixel sub-region 103. Specifically, in the two adjacent pixel units 1, hypotenuses of the two third subpixels 113 are disposed opposite to each other. The two third subpixels 113 are disposed symmetrically. The third pixel sub-region 103 is a third rectangular region. The subpixels with a same color are close to each other and distributed symmetrically, which can lower a color blend phenomenon during an evaporation process to improve display effect of the display panel.

The first subpixels 111 are blue subpixels. The second subpixels 112 are red subpixels. The third subpixels 113 are green subpixels.

A size of the second subpixel 112 is equal to a size of the second subpixel 113. An area of the first subpixel 111 is greater than an area of the second subpixel 112, and is greater than an area of the third subpixel 113. Specifically, the size of the first subpixel 111 is equal to a sum of the size of the second subpixel 112 and the size of the third subpixel 113. Because luminous efficacy and service life of a blue light material is significantly less than a red light material and a green light material in current organic luminescent materials, a larger pixel area can effectively improve the luminous efficacy of an organic light emitting diode (OLED) display device and prolong its service life.

In one of the pixels 11, the pixel definition layer 2 is disposed between the first subpixels 111, the second subpixels 112, and the third subpixels 113. One subpixel is disposed in one via hole of the pixel definition layer 2. Subpixels with three different colors constitute one pixel. Four of the pixels constitute one pixel unit 1.

The technical effect of the display device of this embodiment is that subpixels with a same color are close to each other and can be symmetrical to each other, which can lower a color blend phenomenon caused in an evaporation process to improve display effect of the display device.

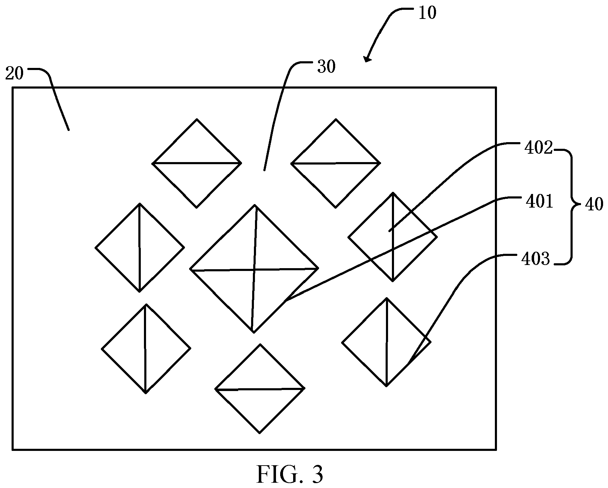

As illustrated in FIG. 3, an embodiment of this embodiment further provides a mask plate 10. The mask plate 10 is used to manufacture the display panel mentioned above. The mask plate 10 includes a plate body 20. The plate body 20 includes a shielding region 30 and an opening region 40.

The opening region 40 includes a first opening area 401, a second opening area 402, and a third opening area 403. A shape and a dimension of the first opening area 401 corresponds to the first pixel sub-region 101 of the display panel. A shape and a dimension of the second opening area 402 corresponds to the second pixel sub-region 102 of the display panel. A shape and a dimension of the third opening area 403 corresponds to the third pixel sub-region 103 of the display panel.

The shapes of the first opening area 401, the second opening area 402, and the third opening area 403 are rectangular.

The technical effect of the mask plate of this embodiment is that one opening of the mask plate corresponds to a pixel sub-region composed by subpixels with a same color, that is, one opening corresponds to two subpixels, which can effectively improve pixel density of the display device.

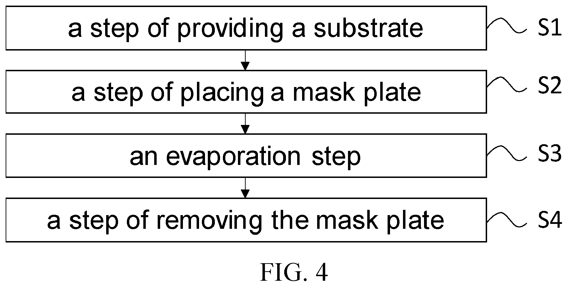

As illustrated in FIG. 4, this embodiment further provides a manufacturing method of the display panel, including steps S1 to S4.

A step of providing a substrate S1: providing a substrate. The substrate includes pixel definition layer. Several via holes are defined on the pixel definition layer. Four first via holes constitute a first pixel sub-region. Two second via holes constitute a second pixel sub-region. Two third via holes constitute a third pixel sub-region. An area of the first pixel sub-region is greater than an area of the second pixel sub-region. The area of the first pixel sub-region is greater than an area of the third pixel sub-region. The area of the second pixel sub-region is equal to the area of the third pixel sub-region. The first pixel sub-region is used for evaporating the first subpixels. The second pixel sub-region is used for evaporating the second subpixels. The third subpixel is used for evaporating the third subpixels. Shapes of the first pixel sub-region, the second pixel sub-region, and the third pixel sub-region are rectangular regions.

A step of placing a mask plate S2: placing the mask plate mentioned above on above of the substrate. The mask plate is bonded to the substrate tightly. The mask plate includes a first opening area, a second opening area, and a third opening area. The first opening area is disposed opposite to the first rectangular region to be used for evaporating the first subpixels. The first subpixels are blue subpixels. The second opening area is disposed opposite to the second rectangular region to be used for evaporating the second subpixels. The second subpixels are red subpixels. The third opening area is disposed opposite to the third rectangular region to be used for evaporating the third subpixels. The third subpixels are green subpixels.

One of the opening areas of the mask plate corresponds to a pixel sub-region composed by subpixels with a same color, and the pixel sub-region is a rectangular region, that is, one opening corresponds to two subpixels, which can effectively improve pixel density of the display device.

An evaporation step S3: evaporating the substrate to form four adjacent first subpixels in the first pixel sub-region, to form two adjacent second subpixels in the second pixel sub-region, and to form two adjacent third subpixels in the third pixel sub-region. One of the first subpixels, one of the second subpixels, and one of the third subpixels which are adjacent form one pixel unit.

A step of removing the mask plate S4: removing the mask plate.

The technical effect of the manufacturing method of the display panel of this embodiment is that one opening of the mask plate corresponds to a rectangular region composed by subpixels with a same color, that is, one opening corresponds to two subpixels, which can effectively improve pixel density of the display device.

In the above embodiments, the description of each embodiment has its emphasis, and for some embodiments that may not be detailed, reference may be made to the relevant description of other embodiments.

The display panel, the manufacturing method thereof, and the mask plate provided by the embodiments of present disclosure are described in detail above. This article uses specific cases for describing the principles and the embodiments of the present disclosure, and the description of the embodiments mentioned above is only for helping to understand the method and the core idea of the present disclosure. It should be understood by those skilled in the art, that it can perform changes in the technical solution of the embodiments mentioned above, or can perform equivalent replacements in part of technical characteristics, and the changes or replacements do not make the essence of the corresponding technical solution depart from the scope of the technical solution of each embodiment of the present disclosure.

## Claims

1. A display panel, comprising a plurality of pixel units;
wherein each of the pixel units comprises four pixels;
each of the pixels comprises a plurality of first subpixels, a plurality of second subpixels, and a plurality of third subpixels; and
the plurality of first subpixels of each of the pixel units are disposed adjacently and form a first pixel sub-region;
wherein in two adjacent pixel units, the plurality of second subpixels of one of the pixel units and the plurality of second subpixels of another one of the pixel units are disposed adjacently and form a second pixel sub-region, and the plurality of third subpixels of one of the pixel units and the plurality of third subpixels of another one of the pixel units are disposed adjacently and form a third pixel sub-region.

2. The display panel as claimed in claim 1, wherein
the plurality of pixels are squares;
the plurality of first subpixels are triangles;
the plurality of second subpixels are triangles; and
the plurality of third subpixels are triangles,
wherein the triangles comprise right triangles.

3. The display panel as claimed in claim 2, wherein when the plurality of first subpixels, the plurality of second subpixels, and the plurality of third subpixels are right triangles,
two sides of the first subpixels forming a right angle are disposed correspondingly to two sides of a square where the pixels are located on; a hypotenuse of the second subpixels corresponds to and is parallel to a side of the pixels, and is disposed on an edge of the pixel units where the pixels are located on; and
a hypotenuse of the third subpixels corresponds to and is parallel to a side of the pixels, and is disposed on an edge of the pixel units where the pixels are located on.

4. The display panel as claimed in claim 3, wherein in the plurality of pixel units, right angles of the plurality of first subpixels of the four pixels are disposed oppositely; and
the first pixel sub-region is a first rectangular region, and the first rectangular region is located at a center of the pixel units.

5. The display panel as claimed in claim 1, wherein in two adjacent pixel units, the second pixel sub-region is a second rectangular region; and
in two adjacent pixel units, the third pixel sub-region is a third rectangular region.

6. The display panel as claimed in claim 1, wherein
an area of the plurality of second subpixels is equal to an area of the plurality of third subpixels; and
an area of the first subpixels is equal to a sum of the area of the plurality of second subpixels and the area of the plurality of third subpixels.

7. The display panel as claimed in claim 1, wherein in each of the pixel units, one of the second subpixels and one of the third subpixels are disposed adjacently, two second subpixels are spaced apart, and two third subpixels are spaced apart.

8. A mask plate used to manufacture the display panel as claimed in claim 1, comprising
a plate body comprising a shielding region and an opening region, wherein the opening comprises a first opening area, a second opening area, and a third opening area,
wherein a shape and a dimension of the first opening area corresponds to the first pixel sub-region of the display panel, a shape and a dimension of the second opening area corresponds to the second pixel sub-region of the display panel, and a shape and a dimension of the third opening area corresponds to the third pixel sub-region of the display panel.

9. The mask plate as claimed in claim 8, wherein
shapes of the first opening area, the second opening area, and the third opening area are rectangular or rhombic.

10. A manufacturing method of a display panel, comprising following steps:
a step of providing a substrate: providing a substrate;
a step of placing a mask plate: placing the mask plate as claimed in claim 8 to make a first opening of the mask plate correspond to the first pixel sub-region of the substrate, a second opening of the mask plate correspond to the second pixel sub-region of the substrate, and a third opening of the mask plate correspond to the third pixel sub-region of the substrate;
an evaporation step: evaporating the substrate, which forms four adjacent first subpixels in the first pixel sub-region, forms two adjacent second subpixels in the second pixel sub-region, and forms two adjacent third subpixels in the third pixel sub-region, wherein one of the first subpixels,
one of the second subpixels, and one of the third subpixels which are adjacent form one of the pixel units; and
a step of removing the mask plate: removing the mask plate.
